# EUROPÄISCHE PATENTANMELDUNG

(11) **EP 2 360 291 A1**
(43) Veröffentlichungstag der Anmeldung: **24.08.2011**
(21) Anmeldenummer: 10154561.4
(22) Anmeldetag: 24.02.2010
(51) Int. Cl.: C23C 14/54, C23C 16/48

(54) **Verfahren und Vorrichtung zum schnellen Heizen und Kühlen eines Substrates und sofort anschließender Beschichtung desselben unter Vakuum**

(71) Anmelder: Singulus Technologies AG, 63796 Kahl am Main (DE)
(72) Erfinder: Maass, Wolfram, Dr., 63589 Linsengericht-Grossenhausen (DE); Ocker, Berthold, 63454 Hanau (DE); Langer, Jürgen, Dr., 63075 Offenbach (DE); John, Helmut, 63452 Hanau (DE)
(74) Vertreter: Heunemann, Dieter

(57) **Zusammenfassung**

Beschrieben wird ein Verfahren zum Heizen/Kühlen und Beschichten eines Substrats (20) in einer Vakuumkammer mit den folgenden Schritten: (1) Anordnen des Substrats mit seiner Unterseite (21a) auf eine Substrat-Halterung (24), (2) Anheben des Substrats um einen vorgegebenen Abstand (d) relativ zur Substrat-Halterung und (3) Heizen des angehobenen Substrats über seine Oberseite mit einer Heiz-Vorrichtung (22), beispielsweise einer Strahlungsheizvorrichtung, (4) Beschichtung des heißen Substrates, beispielsweise durch Bewegen in oder durch eine Beschichtungszone, (5) Abkühlen des Substrates durch Absenken auf den Chuck und (6) ggf. weitere Beschichtung auf das kalte Substrat. Das erfindungsgemäße Verfahren erlaubt es darüber hinaus, Prozess-Sequenzen durchzuführen, bei denen in den einzelnen Schritten auf dem Substrat definierte unterschiedliche Temperaturen eingestellt und - gegebenenfalls - sofort anschließend eine oder mehrere Beschichtungen bei dieser Substrat-Temperatur durchgeführt werden. Das schließt z.B. auch den Fall ein, dass ein Substrat direkt nach einer Beschichtung für eine gewisse Zeit auf höherer Temperatur gehalten werden kann (Tempern).

## Beschreibung

Die vorliegende Erfindung betrifft ein Verfahren und eine Vorrichtung zum Aufheizen und/oder Abkühlen eines Substrats in einer Vakuumkammer. Das aufgeheizte Substrat kann dann beispielsweise unmittelbar danach mit einer bestimmten Beschichtung versehen werden und anschließend auf eine niedrigere Temperatur abgekühlt werden.

Beschichtung von Substraten mit dünnen Schichten unter Vakuum mittels Sputtern (PVD), Chemical Vapor Deposition (CVD), Aufdampfen und weiteren Verfahren, ist ganz allgemein ein viel verwendetes Verfahren in der Industrie, um spezielle Funktionsschichten herzustellen. Typische Beispiele sind die Halbleiterindustrie und inzwischen auch die Solarindustrie bei der Herstellung von Solarzellen. Ohne daß damit eine Beschränkung der Anwendbarkeit des hier vorgestellten Verfahrens beabsichtigt ist, soll dieses Verfahren hier am Beispiel der Herstellung spezieller magnetischer Mehrlagenschichten erläutert werden.

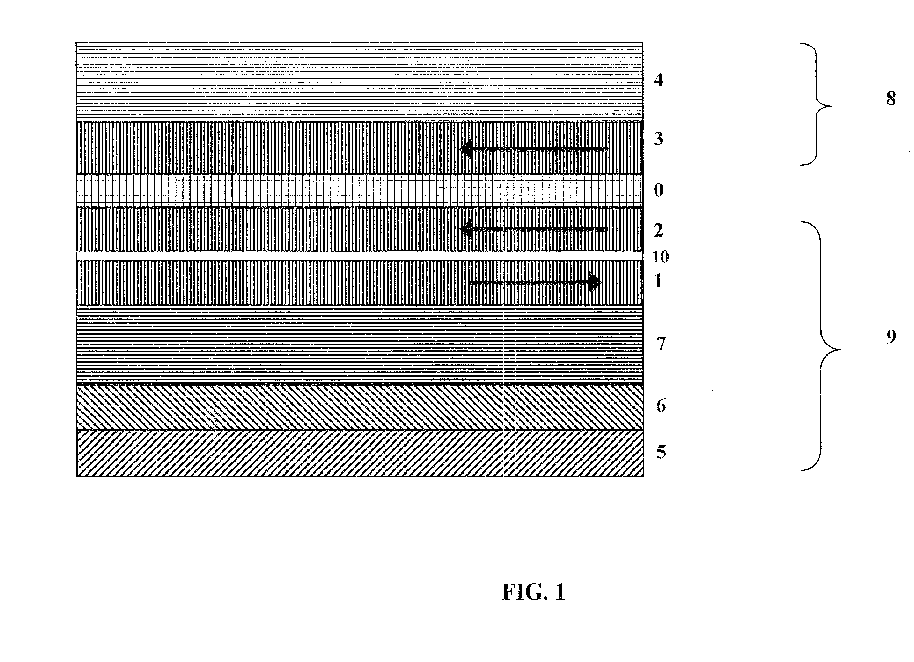

Die Herstellung wohl-definierter dünner Schichten (Layer) und Mehrlagenschichten (multi-layer) auf einem Substrat in einer Vakuumkammer ist z.B. bei der Realisierung von magnetischen Tunnelkontakten wichtig. Solche magnetische Tunnelkontakte sind ein wesentliches Element von MRAMs. ("Magneto-resistive Random Access Memory"), werden aber z.B. auch als Magnetfeld-Sensoren zum Lesen von gespeicherten Informationen in Dünnschicht-Köpfen von Festplatten verwendet. Dabei kommt der sogenannte TMR (Tunnel-Magneto-Resistance)- aber auch der sogenannte GMR (Giant-Magneto-Resistance)-Effekt zum Tragen. Ein Beispiel für ein typisches Schichtpaket ist in Fig. 1 gezeigt.

Die Schichten 1, 2 (bestimmter magnetischer Ausrichtungen, "pinned layers") und 3 ("free layer") sind hierbei aus ferromagnetischem Material hergestellt. Die dargestellten Pfeile zeigen die Richtung der Magnetisierung an, die in der Schichtebene liegt. Die Dicken der einzelnen Schichten variieren von weniger als 1,0 nm bis zu einigen 10,0 nm.

Neueste Entwicklungen zeigen, dass es für die Herstellung hochdichter MRAMs notwendig ist, die Magnetisierungsrichtung zumindest bei einigen der im Schichtstapel vorhandenen ferromagnetischen Schichten senkrecht zur Schichtebene auszurichten. Eine derartige senkrechte Ausrichtung der Magnetisierung kann unter anderem dadurch erreicht werden, dass bestimmte ferromagnetische Legierungen (z.B. CoPt, FePt, FePd) mittels Kathodenzerstäubung auf ein heißes Substrat aufgebracht werden. Die erforderlichen Temperaturen des Substrates liegen hierbei bei 250°C bis zu 500°C. Andere Schichten im Schichtstapel müssen dagegen wie bisher auf das Substrat bei Raumtemperatur abgeschieden werden, um die erforderlichen Eigenschaften zu erreichen.

Im Bereich der Schreib- und Leseköpfe für magnetische Festplatten kann der Einsatz von speziellen ferromagnetischen Materialien mit einer hohen Spinpolarisation in ähnlich aufgebauten Schichtsystemen wie in Fig. 1 gezeigt von Vorteil sein. Bei den genannten Materialien handelt es sich vor allem um die sogenannten Heusler-Legierungen. Für das Erreichen der gewünschten Schichteigenschaften ist es auch hier notwendig, dass das Material auf ein heißes Substrat aufgebracht wird. Allerdings müssen auch hier andere Schichten in dem Schichtstapel auf das Substrat bei Raumtemperatur aufgebracht werden.

Auch bei anderen Beschichtungsprozessen - nicht nur im Zusammenhang mit magnetoresistiven Sensoren - kann das Aufbringen von dünnen Schichten auf Substrate mit wohldefinierter - meist hoher - Temperatur im Wechsel mit anderen "kalten" Prozeßschritten wünschenswert sein.

Für derartige Beschichtungsvorgänge, die üblicherweise in einer Vakuumkammer stattfinden, müssen demnach mehrere Bedingungen und Aspekte beachtet werden.
a) Generell sollte die Herstellung der oben beschriebenen Dünnschichtsysteme in möglichst kurzer Zeit erfolgen. Dabei kommt es fast immer darauf an, die Zeit zwischen den Beschichtungen der einzelnen Schichten sehr kurz zu halten, um die Qualität der Grenzflächen zwischen den Schichten nicht zu verschlechtern. Zum anderen würden lange Herstellungsprozesse zu einer schlechten Produktivität führen. Typische Beschichtungszeiten sind einige Sekunden bis zu einigen zehn Sekunden. Die Pausen zwischen den einzelnen Beschichtungen sollten ebenfalls in dieser Größenordnung liegen.
b) Typischerweise werden Substrate zur Beschichtung in einer Vakuumkammer auf einem Substrathalter gehalten. Im Falle von Silizium-Wafern, die z.B. bei der Herstellung von Halbleitern verwendet werden, handelt es sich dabei meist um eine gekühlte Halte-Vorrichtung.
c) Das Substrat sollte bei den Beschichtungsvorgängen meistens eine bestimmte Temperatur (abhängig von dem Schichtmaterial) aufweisen. Allerdings ist es derzeit nicht möglich, das Substrat schnell auf eine andere Temperatur aufzuheizen oder abzukühlen und danach z.B. sofort zu beschichten. Wenn z.B. das Heizen und Kühlen über die Halte-Vorrichtung geschehen soll, müsste die Halte-Vorrichtung in kurzer Zeit von den angegebenen hohen Temperaturen wieder auf Raumtemperatur abgekühlt werden, was besonders schwierig erscheint, da eine Abkühlung mittels Konvektion im Vakuum nicht möglich ist und solche Halte-Vorrichtungen notwendigerweise eine relativ große (auch thermische) Masse haben.
d) In der Halbleiterindustrie wird oft eine einzelne Schicht auf ein heißes Substrat abgeschieden. Die technische Lösung ist in diesem Fall, die Beschichtung in einer speziellen Vakuumkammer vorzunehmen, die mit einem heizbaren Waferhalter (Chuck) ausgerüstet ist. Dieser Chuck wird permanent auf der hohen Temperatur gehalten und der Wafer für die Beschichtung auf dem heißen Chuck abgelegt. Nach der Beschichtung wird der Wafer ggf. in eine weitere Prozesskammer z.B. mit einem Vakuum-Roboters bewegt, um weitere (z.B. "kalte") Prozessschritte durchzuführen. Diese Art und Weise, Beschichtungen auf heiße Substrate aufzubringen, lässt sich allerdings für die angesprochenen magnetischen und andere Mehrlagenschichten, wobei einzelne Schichten eine andere Substrattemperatur erfordern, nicht erfolgreich anwenden. Wie unter a) diskutiert, wäre ein in den meisten Fällen mehrfacher Transport des Substrates von einer Vakuum-Beschichtungskammer in eine andere und wieder zurück weder aus prozesstechnischen noch aus ökonomischen Gründen (Durchsatz) akzeptabel.
e) In der Halbleiterindustrie ist es ebenfalls ein übliches Verfahren, Substrate mittels Infrarot-Strahlern in speziellen Vakuumkammern schnell auf eine hohe Temperatur zu bringen (RTP - Rapid Thermal Processing). Eine Beschichtung der Substrate in solchen Vakuumkammer ist nicht möglich, da die Position des Beschichtungswerkzeuges von dem Heizstrahler eingenommen wird.

Es ist somit Aufgabe der vorliegenden Erfindung, ein Verfahren und eine Vorrichtung bereitzustellen, die ein schnelles kontrolliertes Aufheizen und Abkühlen eines Substrats und eine jeweils sofort danach erfolgende Beschichtung in nur einer Vakuumkammer ermöglicht. Dieser Vorgang des Temperierens des Substrates (Heizen oder Kühlen) und anschließender Beschichtung soll im Sinne der Erfindung mehrfach sequentiell durchführbar sein, um Mehrlagenschichten mit jeweils definierter Substrattemperatur bei der Einzelbeschichtung herstellen zu können.

Diese Aufgabe wird durch den Gegenstand der Ansprüche gelöst.

Die Erfindung geht von dem Grundgedanken aus, zum Aufheizen und gegebenenfalls zum Beschichten des (heißen) Substrates dieses von der (gekühlten) Substrat-Halterung abzuheben. Die Substrat-Halterung kann daher in diesem gekühlten Zustand verbleiben, so dass durch späteres Absenken des aufgeheizten Substrats auf die gekühlte Halterung das Substrat wieder abgekühlt wird. Auf diese Weise können kurze Aufheiz- und Abkühlzeiten eines Substrats mit jeweils sofort danach erfolgender Beschichtung in der Vakuumkammer realisiert werden.

Die Erfindung betrifft ein Verfahren zum Heizen/Kühlen und Beschichten eines Substrats in einer Vakuumkammer mit den folgenden Schritten: (1) Anordnen des Substrats mit seiner Unterseite auf eine Substrat-Halterung, (2) Anheben des Substrats um einen vorgegebenen Abstand relativ zur Substrat-Halterung und (3) Heizen des angehobenen Substrats über seine Oberseite mit einer Heiz-Vorrichtung, beispielsweise einer Strahlungsheizvorrichtung, (4) Beschichten des geheizten Substrates, beispielsweise durch Bewegen in oder durch eine Beschichtungszone, (5) Abkühlen des Substrates durch Absenken auf den Chuck und (6) ggf. weitere Beschichtung auf das kalte Substrat.

Die Erfindung erlaubt es darüber hinaus, Prozess-Sequenzen durchzuführen, bei denen in den einzelnen Schritten auf dem Substrat definierte unterschiedliche Temperaturen eingestellt und - ggf. - sofort anschließend eine oder mehrere Beschichtungen bei dieser Substrat-Temperatur durchgeführt werden. Das schließt auch den Fall ein, dass ein Substrat direkt nach einer Beschichtung für eine gewisse Zeit auf höherer Temperatur gehalten werden kann (Tempern).

Ein Substrat im Sinne dieser Erfindung kann z.B. ein Silizium-Wafer oder ein anderer Träger sein, der entweder bereits beschichtet ist oder noch nicht. Die die Heiz- und Beschichtungsvorrichtung enthaltende Vakuumkammer kann Teil einer Gesamtanlage sein, mit der weitere Prozesskammern verbunden sind. Erfindungsgemäß kann eine Transportvorrichtung, wie ein Roboter(arm), in der Vakuumkammer vorgesehen sein, um das Substrat, gegebenenfalls zusammen mit der Substrat-Halterung hin- und herzubewegen. In der Vakuumkammer vorhandenes Gas kann z.B. mit Hilfe von Vakuumpumpen aus der Kammer entfernt werden, so dass z.B. ein Vakuum von weniger als 10⁻⁷, insbesondere weniger als 10⁻⁸, vorzugsweise 10⁻⁹ mbar oder auch weniger in der Vakuumkammer erreicht wird.

Bei aufliegendem Substrat ist deren Unterseite in flächigem Kontakt mit der Substrat-Halterung. Die Oberseite des Substrats, die nach dem Heizen beschichtet werden soll, soll mit der Substrat-Halterung typischerweise nicht in Kontakt kommen.

Durch Ablegen des Substrats mit seiner Unterseite auf der Substrat-Halterung wird das Substrat zur weiteren Behandlung seiner Oberfläche bereitgestellt. Die Substrat-Halterung kann z.B. das Substrat mittels elektrostatischer Kräfte fixieren ("Electrostatic Chuck", ESC); derartige Substrat- oder Waferhalter können je nach Größe der Substrate eine erhebliche Masse von z.B. einigen Kilogramm aufweisen.

Solche Substrat-Halterungen können auf verschiedene Art und Weise ausgeführt sein. Wesentlich ist, daß eine plane Fläche zur Verfügung gestellt ist, Zum Beispiel kann die Substrat-Halterung eine Aussparung aufweisen, in die das Substrat hineingelegt werden kann, oder plan ausgebildet ist, so dass die Unterseite des Substrats auf/an diese plane Seite/Fläche der Halterung angelegt oder abgelegt werden kann. In beiden Fällen können Finger oder Greifer an/in der Halterung vorgesehen sein, die in der Halterung versenkbar und von dieser wegschwenkbar sind und/oder aus dieser derart herausfahrbar oder schwenkbar sind, so dass mit ihrer Hilfe das Substrat gegenüber dem Rest der Halterung angehoben werden kann. Vorzugsweise weisen die Kontaktflächen der Finger oder Greifer zu dem Substrat kleinstmögliche Abmessungen auf, z.B. weniger als 10%, insbesondere weniger als 5%, typischerweise weniger als 1% der Fläche der Unterseite des Substrats (die Oberseite und die Unterseite des Substrats haben in allen praktischen Fällen die gleiche Größe). Alternativ oder auch zusätzlich kann die Substrat-Halterung auch derart konfiguriert sein, dass die Finger oder Greifer das Substrat halten, während der Rest der Halterung sich absenkt.

In einer Ausführungsform weist die Substrat-Halterung mindestens zwei, insbesondere drei oder vier Finger, und/oder mindestens einen Greifer auf. Als Finger kommen hier z.B. schmale Schäfte in Frage, z.B. mit einem Durchmesser von weniger als 2 mm. Ein Greifer kann z.B. derart konfiguriert sein, dass er das Substrat an der Unterseite und einer Seite greift, wobei die Kontaktflächen zum Substrat dabei nicht die oben erwähnten Bereiche überschreiten. Ein Greifer kann auch eine (bilder-)rahmenförmige Vorrichtung oder teilweiser Rahmen (z.B. nur aus den Rahmenecken bestehend) sein, auf/in den das Substrat an-/hineingelegt wird und somit eine sehr geringe Kontaktfläche wie oben erwähnt zu der Substrat-Halterung aufweist.

In einer Ausführungsform können die Finger oder der/die Greifer aus einem Material (z.B. Keramik) hergestellt sein, das nur eine geringe oder praktisch keine Wärmeleitung aufweist. Auf diese Weise wird so wenig Wärmeenergie wie möglich von dem gerade beheizten oder dem fertig aufgeheizten Substrat auf die (eventuell sogar gekühlte) Substrat-Halterung übertragen.

In einer Ausführungsform wird die Substrat-Halterung gekühlt.

Zum Beispiel kann die Substrat-Halterung mit Wasser gekühlt werden und hierzu entsprechende Kühl-Kanäle aufweisen. Zur besseren Abführung von Wärmeenergie vom aufliegenden Substrat auf die Substrat-Halterung können in deren, insbesondere ansonsten planen, Kontaktfläche zum Substrat Kontaktgaskanäle, z.B. in Form von Nuten, zum Durchleiten von Helium oder Argon als Kontaktmittel zwischen dem Substrat und der Substrat-Halterung vorgesehen sein.

Dadurch kann ein z.B. geheiztes Substrat nach einer Beschichtung und/oder vor einer (weiteren) Beschichtung gekühlt oder aber auch bei anderen Prozess-Vorgaben schnell und effektiv auf eine gewünschte Temperatur gebracht werden.

In einer Ausführungsform wird das Substrat um 0,1 bis 20 mm, insbesondere um 1 bis 10 mm, vorzugsweise 2 bis 5 mm angehoben.

Auf diese Weise wird die Wärmeleitung zu dem kühleren Substrat-Halter praktisch vollständig verhindert, so dass das Substrat effektiv und schnell aufgeheizt werden kann.

Das Heizen des Substrats erfolgt über eine Heizvorrichtung, insbesondere über eine Strahlungsheizvorrichtung, die sich in der Vakuumkammer befindet und mit der das Substrat auf eine bestimmte Temperatur aufgeheizt wird. Diese Temperatur kann z.B. vor dem Heizprozess von außen einstellbar sein.

Typischerweise wird das auf eine Solltemperatur gebrachte Substrat in angehobener Position beschichtet. Dagegen kann ein gekühltes Substrat typischerweise im abgesenkten und in engem Kontakt mit der planen gekühlten Fläche des Substrathalters befindlichen Zustand beschichtet werden.

Zum Beispiel kann das aufgeheizte Substrat im angehobenen Zustand innerhalb von wenigen Sekunden, insbesondere innerhalb von weniger als 2 Sekunden in die Beschichtungsposition innerhalb der Vakuumkammer gebracht werden, in der es beschichtet werden kann. Hierzu ist z.B. in die Vakuumkammer eine Beschichtungsvorrichtung so integriert, dass die Substrat-Halterung mit dem angehobenen und aufgeheizten Substrat einfach und schnell in Richtung dieser Beschichtungsvorrichtung gebracht werden kann. Gleichermaßen wird bei gekühltem Substrat im abgesenkten Zustand vorgegangen. Die Beschichtungsvorrichtung kann sich auch in einer benachbarten Kammer befinden, so dass die Substrat-Halterung mit dem Substrat mit einem Roboter(arm) in diese hineingebracht werden kann.

In einer Ausführungsform wird das Substrat in eine Richtung parallel zur Unterseite des Substrats bewegt.

Zum Beispiel kann sich die Beschichtungsvorrichtung in der Vakuumkammer neben der Heizungsposition befinden, so dass durch ein seitlichen Verschieben des Substrats mit der Substrat-Halterung parallel zur Substratfläche diese Beschichtungsvorrichtung erreicht werden kann.

Auf diese Weise ist ein schneller und einfacher Transport des Substrats möglich, und die Beschichtung kann ohne weitere Verzögerung auf dem auf eine bestimmte Temperatur gebrachten Substrat beginnen.

In einer Ausführungsform wird das Heizen des angehobenen Substrats über einen Sensor kontrolliert.

Dieser Sensor kann z.B. ein Pyrometer sein, der sich in der Vakuumkammer befindet und die tatsächliche Temperatur des Substrats misst. Der Sensor bzw. das Pyrometer kann sich alternativ außerhalb der Vakuumkammer befinden und die Temperatur des Substrats z.B. durch ein Kammer-Fenster bestimmen. Typische Pyrometer ermöglichen dabei einen sehr kleinen Messfleck von ca. 1 mm² bei einem Abstand von 40 cm zwischen dem Pyrometer und dem Substrat. Verglichen mit einer Temperaturmessung über ein Thermoelement in der Kammer ist die pyrometrische Messung durch ein Kammer-Fenster vorteilhaft, da der pyrometrische Sensor nicht mit dem Substrat in Kontakt sein muß und ggf. auch nicht von reaktiven Gasen in der Prozesskammer angegriffen wird. Das Pyrometer kann in einer besonderen Ausführungsform mit einem Regler verbunden sein, der wiederum von einem PC aus programmierbar ist, so dass die Ergebnisse des Pyrometers derart analysiert werden können, dass der Heizer entsprechend an- oder auch nachgesteuert werden kann, um die korrekte Temperatur des Substrats einzustellen und erforderlichenfalls auch konstant zu halten.

Auf diese Weise lassen sich selbst kompliziertere Temperaturverläufe für das Substrat präzise und einfach steuern, insbesondere mit jeweils anschließender Beschichtung.

Nach einer Beschichtung kann es vorteilhaft sein, das Substrat auf eine niedrigere Temperatur abzukühlen und insbesondere danach wiederum zu beschichten. Dies kann zum Beispiel dadurch geschehen, dass das Substrat auf die (kühlere) Substrat-Halterung abgesenkt wird.

In einer Ausführungsform wird das Substrat kontrolliert gekühlt.

Eine kontrollierte Kühlung des Substrats kann z.B. dadurch erfolgen, dass die Substrat-Halterung gesteuert gekühlt wird. Zum Beispiel kann der Sensor bzw. das Pyrometer mit der Steuerung für die Kühlung der Substrat-Halterung koppelbar sein, so dass ein auf die Substrat-Halterung abgesenktes Substrat auf eine bestimmte Temperatur abkühlbar ist.

Bei einer weiteren erfindungsgemäßen Ausführungsform kann ein, insbesondere vorab auf Solltemperatur gebrachter, Wärmespeicher zwischen das angehobene Substrat und die Substrat-Halterung eingebracht werden, um einen eventuellen Temperaturabfall des Substrats zu kompensieren. Der Wärmespeicher kann z.B. eine große thermische Masse aufweisen und kann vorzugsweise auf seiner zum Substrat hin weisenden Seite schwarz, aber auf allen anderen Flächen oder zumindest auf der zur Substrat-Halterung hin weisenden Fläche so präpariert sein, dass die Wärmeabstrahlung in die Kammer oder in Richtung der Substrat-Halterung minimiert wird. Dieser Wärmespeicher kann z.B. auch zusammen mit dem Substrat und dem Substrat-Halter für die Beschichtung hin- und herbewegt werden, um ein wesentliches Abkühlen des Substrats während des Beschichtungsvorgangs zu vermeiden.

In einer Ausführungsform wird das Substrat vor einer folgenden Beschichtung eine längere Zeit, insbesondere einige Minuten, vorzugsweise mindestens 10 Minuten, auf einer bestimmten Temperatur gehalten.

In einer Ausführungsform wird in dem erfindungsgemäßen Verfahren ein Heizen und/oder Abkühlen des Substrats auf verschiedene, bestimmte Temperaturen, insbesondere mit jeweiliger anschließender Beschichtung, sequentiell durchgeführt. Hierzu kann eine Steuerung vorgesehen sein, die den Ablauf der Verfahrensschritte, z. B. in mehreren Einzelschritten bei Mehrfachbeschichtungen eines Substrats, kontrolliert.

Die Erfindung betrifft auch ein System zum Heizen eines Substrats in einer Vakuumkammer. Das System weist eine Substrat-Halterung, eine Hubvorrichtung zum Anheben des Substrats, das mit seiner Unterseite auf der Substrat-Halterung angeordnet ist, und eine Heizvorrichtung auf, um das angehobene Substrat über dessen Oberseite zu heizen.

Merkmale, die in Zusammenhang mit dem Verfahren gemäß der Erfindung beschrieben wurden, können ebenso vorteilhaft sein als Merkmale des Systems gemäß der Erfindung und umgekehrt. Ebenso sollen die Erläuterungen zu den beschriebenen Merkmalen des Verfahrens ebenfalls für die Merkmale des Systems der Erfindung gelten.

In einer Ausführungsform befindet sich die Hubvorrichtung an der Substrat-Halterung. Mit anderen Worten, die Hubvorrichtung kann z.B. in die Substrat-Halterung integriert sein. Zum Beispiel kann die Hubvorrichtung die Finger und/oder den/die Greifer wie oben beschrieben aufweisen.

In einer Ausführungsform ist die Hubvorrichtung derart konfiguriert, dass ein signifikanter Wärmestrom zwischen Substrat-Halterung und Substrat im angehobenen Zustand verhindert wird.

In einer Ausführungsform weist die Substrat-Halterung in der zum Substrat weisenden Oberfläche mindestens einen Kontaktgas-Kanal zum Durchleiten von Kontaktgas auf, um den Wärmeübergang zwischen Substrat und Substrat-Halterung zu erhöhen.

In einer Ausführungsform weist das System eine Steuerung zur kontrollierten Kühlung der Substrat-Halterung auf.

In einer Ausführungsform weist das System einen Temperatur-Sensor für ein kontrolliertes Heizen des Substrats auf.

In einer Ausführungsform ist die Substrat-Halterung in eine Richtung parallel zur Substratunterseite bewegbar.

In einer besonderen Ausführungsform wird das oben beschriebene Verfahren mit dem oben beschriebenen System ausgeführt.

Die Erfindung wird im Folgenden mit Bezug auf die Zeichnungen im Sinne eines Beispieles (magnetische Mehrlagenschichten) näher erläutert. Zudem können auch andere Methoden der Beschichtung der auf eine definierte Temperatur gebrachten Substrate im Sinne der Erfindung möglich und vorgesehen sein.
Figur 1 zeigt schematisch eine typische Schichtstruktur mit oberer und unterer Elektrode, wie sie im Beispiel von TMR Schichtsystemen für MRAM und TFH Verwendung finden;
Figur 2 zeigt schematisch ein Beispiel von Kathodenzerstäubung unter Verwendung eines Targets mit dazugehörigem Magnet-Array und einem Substrat auf dem Weg in die Beschichtungszone;
Figuren 3a-c zeigen schematisch den Ablauf des Verfahrens zum Heizen eines Substrats;
Figur 4 zeigt schematisch einen Temperaturverlauf für ein Substrat;
Figur 5 zeigt schematisch das Prinzip aus Fig. 2 mit Substrat-Halterung; und
Figur 6 zeigt schematisch die Anordnung eines Wärmespeichers auf dem Substrat-Halter.

In Figur 1 wird beispielhaft ein typisches TMR Schichtpaket gezeigt. Die Schichten 1, 2 (bestimmter magnetischer Ausrichtungen, "pinned and reference layer") und die Schicht 3 ("free layer") sind hierbei aus ferromagnetischem Material hergestellt und über eine Magnesiumoxid-Schicht 0 voneinander getrennt. Die dargestellten Pfeile zeigen die Richtung der Magnetisierung an, die in der Schichtebene liegt. Die Dicken der einzelnen Schichten variieren von weniger als 1,0 nm bis zu einigen 10,0 nm. Die Schicht 3 ("free layer") bildet mit einer Schicht 4 ("capping layer") die obere Elektrode 8. Die untere Elektrode 9 besteht aus den Schichten 5 ("seed layer no. 1") und 6 ("seed layer no. 2") und der Schicht 7 ("pinning layer" aus einem antiferromagnetischen Material, wie z.B. PtMn, IrMn), sowie aus dem Paket der Schichten 1 ("pinned layer"), 10 ("coupling layer") und 2 ("reference layer").

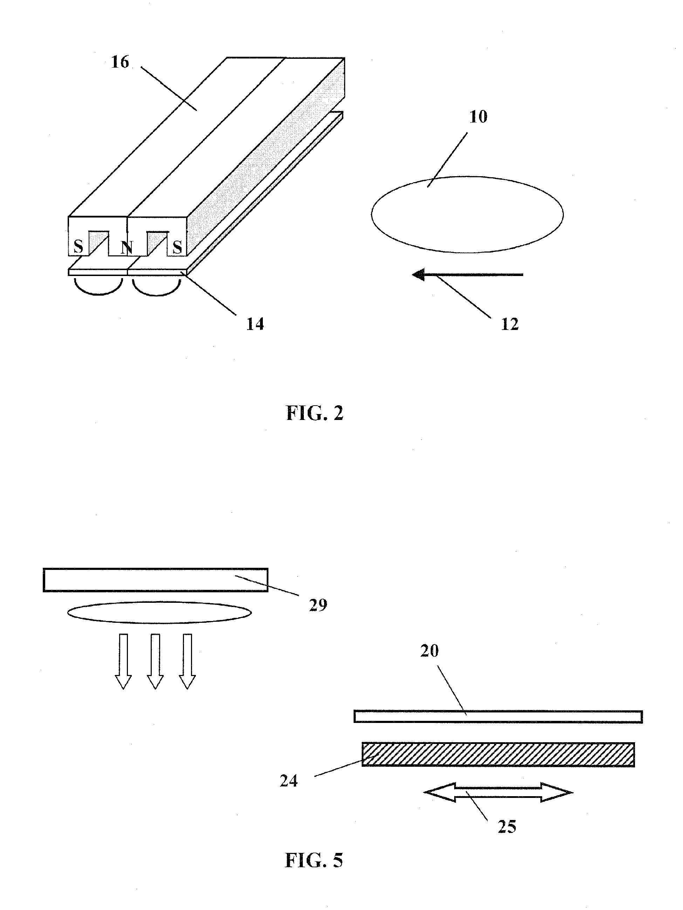

Im Folgenden wird - im Sinne eines Beispiels - eine spezielle Verfahrensweise zur Herstellung von Mehrlagenschichten mittels Kathodenzerstäubung anhand von Fig. 2 erläutert, bei der das Beschichten einzelner Materialien auf Substrate mit definierter - ggf. hoher - Temperatur wie zuvor beschrieben durchgeführt wird. Die Zerstäuberkathode weist ein Magnet-Array 16 auf, um die Elektronen, welche für die Ionisierung des Plasmas verantwortlich sind, in der Nähe der Oberfläche des Targets 14 zu bündeln. Bei dieser "linearen dynamischen" Beschichtung (engl. "Linear Dynamic Deposition" - LDD) wird das Substrat 10, z.B. ein (Silizium-)Wafer, geradlinig unter der (z.B. rechteckigen) Zerstäubungskathode 14, 16 vorbei geführt (siehe Pfeilrichtung 12), so dass die Beschichtung während der Passage (dynamisch) erfolgt.

Diese Verfahrensweise steht z.B. in Kontrast zu den in der Halbleiterindustrie üblichen Verfahren, bei denen der Wafer während der Beschichtung ohne Relativbewegung, also statisch, unter der Beschichtungskathode ruht.

Die LDD-Methode kann nun kombiniert werden mit einer Vorrichtung, die mehrere Beschichtungskathoden enthält, so dass im Wechsel verschiedene Schichten auf das Substrat ohne Zeitverlust aufgebracht werden können. Damit können z.B. auch die gewünschten Mehrlagenschichten aus unterschiedlichen Materialien hergestellt werden, ohne dass längere Transportzeiten anfallen. Um das Substrat 10 für die Beschichtungsschritte zu bewegen, ist es auf einer Substrat-Halterung festgehalten. Dabei kann es sich z.B. um einen (mit Wasser) gekühlten ESC handeln, in dessen Oberfläche zur besseren Abführung von Wärmeenergie Kanäle so integriert sind, dass Helium oder Argon als Kontaktmittel zwischen Substrat 10 und ESC verwendet werden können.

Bei der Herstellung einer Mehrlagenschicht mittels der LDD wird z.B. zunächst das Substrat 10 aus einer Vakuum-Transportkammer mit einem Roboter in die Beschichtungskammer gebracht und auf dem Chuck (Substrat-Halterung) abgelegt. Transportkammer und Beschichtungskammer können dann über ein Schleusenventil voneinander getrennt werden. Das Substrat 10 kann z.B. nach Einschalten einer elektrischen Spannung mit elektrostatischen Kräften auf dem Chuck fixiert werden. Auch kann unter dem Substrat 10 ein Gaspolster erzeugt sein/werden, um eine gute Kühlung zu erreichen. Das "Kühlgas" kann mit Dichtungen von der übrigen Vakuumkammer ferngehalten werden.

Die ausgewählte Zerstäubungskathode 14, 16 wird gezündet und das Substrat 10 ein oder mehrere Male durch die Beschichtungszone bewegt bis die gewünschte Schichtdicke erreicht ist. Im Anschluss kann die nächste Kathode ausgewählt und gezündet und somit die nächste Schicht des Stapels aufgebracht werden usw..

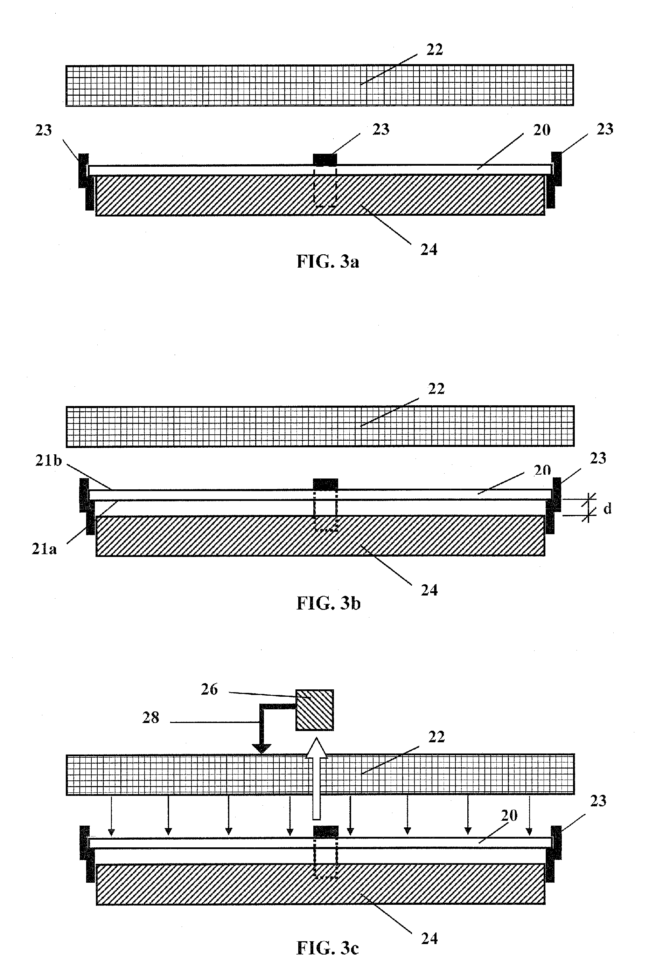

Anhand der Fig. 3a-3c wird nun das Prinzip der vorliegenden Erfindung näher erläutert. Die schnelle Heizung eines Substrats 20 kann nun derart erfolgen, dass z.B. die Substrat-Halterung 24 mit aufgebrachtem Substrat 20 innerhalb der Vakuumkammer vor der Beschichtung in eine Heiz-Station gebracht wird, in der oberhalb des Substrats 20 (Wafers) bzw. des Chucks 24 eine Heizvorrichtung 22, z.B. ein Heizstrahler oder ein Array aus Heizstrahlern gegenüber der Oberseite 21b des Substrats 20 positioniert ist. Vor dem Heizschritt liegt das Substrat 20 mit seiner Unterseite 21 a zunächst auf dem Chuck 24, wie in Fig. 3a zu sehen. In diesem Zustand des Substrats 20 können bereits eine oder mehr Schichten bei Raumtemperatur oder bei anderen Temperaturen auf das Substrat aufgebracht worden sein, oder das Substrat weist noch keine Beschichtung auf.

Zum Heizen wird das Substrat 20 vom Chuck 24 angehoben, z.B. so dass es diesen nicht mehr über die Unterseite 21a des Substrats 20 berührt. Eine spezielle Verriegelung kann z.B. dafür sorgen, dass das Substrat 20 zwar mit dem Chuck 24 verbunden bleibt, z.B. über drei oder vier ,"Finger" 23, die das Substrat 20 am Rand halten und derart konfiguriert sind, dass sie eine geringe und/oder vernachlässigbare Wärmeleitfähigkeit zeigen, aber ein Abstand d von einigen (z.B. 2 bis 3) Millimetern eingehalten wird, wie in Fig. 3b angedeutet.

Anschließend wird die Heizvorrichtung 22 eingeschaltet und das Substrat 20 auf die gewünschte Temperatur gebracht. Die Messung der Temperatur kann z.B. mit einem Pyrometer 26 erfolgen. Die Geschwindigkeit des Temperaturanstieges und/oder die Endtemperatur können über einen Regelkreis 26, 28 eingestellt werden, wie in Fig. 3c gezeigt. Da das Substrat 20 selbst z.B. nur eine geringe thermische Masse hat, lässt sich ein schneller Temperaturanstieg erreichen. Der Gesamtaufbau der Substrat-Halterung 24 und die Installation geeigneter gekühlter Abschirmungen können ferner dafür sorgen, dass möglichst nur das Substrat 20 geheizt wird, während andere Teile der Substrat-Halterung 24 eine möglichst geringe Temperaturerhöhung erfahren.

Das Substrat 20 schirmt die Substrat-Halterung gegenüber der Strahlung der Heizvorrichtung 22 (zumindest teilweise) so ab, dass sich die Temperatur der Substrat-Halterung 24 kaum ändert und vorzugsweise konstant bleibt.

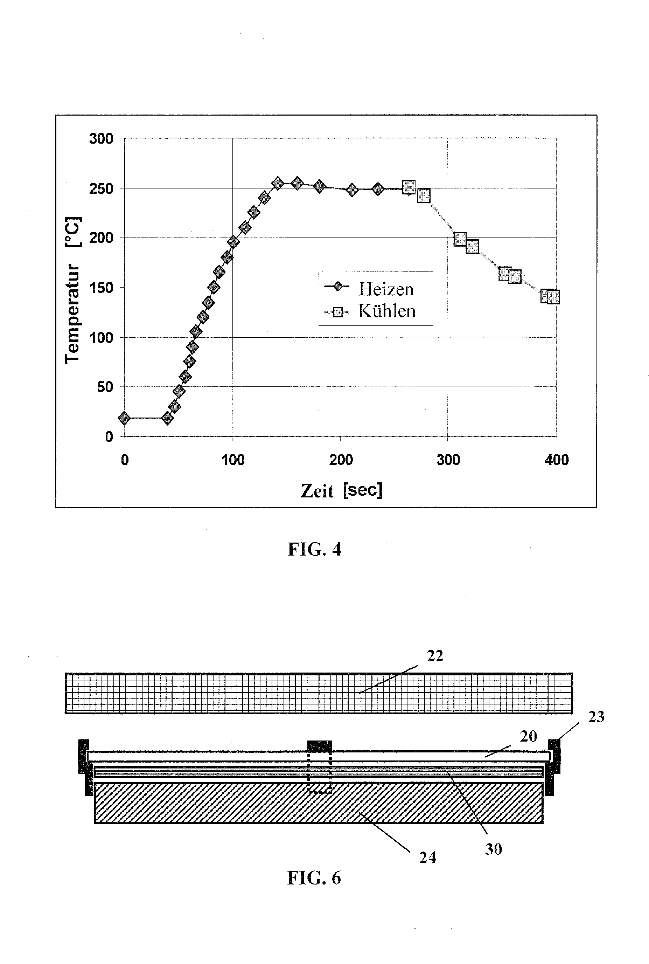

Ein typische Temperaturverlauf des Substrats ist in Fig. 4 gezeigt.

Fig. 5 zeigt nun - in Anlehnung an das Prinzip von Fig. 2 - wie ein Substrat, in diesem Fall ein Substrat 20, beschichtet werden kann, das bereits über die Heizvorrichtung geheizt und auf die Solltemperatur gebracht wurde. Sobald die Solltemperatur erreicht ist, kann der Chuck 24 mit dem angehobenen heißen Substrat bewegt werden oder sich automatisch gesteuert bewegen (siehe Pfeilrichtung 25), damit die (nächste) Beschichtung durchgeführt werden kann, wie in Fig. 5 angedeutet. Da die Zeit zwischen dem Heizen des Substrats 20 und der Beschichtung sehr kurz ist (z.B. nur einige Sekunden), findet keine oder nur eine geringe Abkühlung des Substrats bis zum Beginn der Beschichtung statt.

Sollte sich das Substrat vor allem während mehrerer Beschichtungspassagen zu stark abkühlen, kann zwischen den Beschichtungen ein weiterer Heizschritt vorgesehen sein und dazu das Substrat 20 mit der Substrat-Halterung 24 aus der Kathodenzerstäuber-Station 29 herausbewegt und unter die Heizvorrichtung und schließlich zurück zu einer Beschichtungsstation gefahren werden.

Nach der Beschichtung bei hoher Temperatur können das Substrat 20 und der Chuck 24 z.B. wieder in die Position unter der Heizung gebracht und das Substrat 20 auf den Chuck 24 abgelegt, ggf. auch elektrostatisch auf den Chuck 24 gepresst werden. Mit Hilfe des gekühlten Chucks 24 und durch die Verwendung des Kontaktgases kann eine schnelle Abkühlung des Substrats 20 erfolgen. Dabei kann z.B. durch Einstellung des Kontaktgas-Druckes die Geschwindigkeit der Abkühlung eingestellt werden.

Anschließend können, z.B. auch in einer anderen Beschichtungsstation, weitere Schichten des Schichtsystems auf das gekühlte/kalte Substrat z.B. bei Raumtemperatur oder einer anderen Temperatur aufgebracht werden.

Erfindungsgemäß kann zudem ein vorher auf eine Solltemperatur gebrachter Wärmespeicher 30 zwischen das angehobene Substrat 20 und den Chuck 24 eingebracht werden, um einen eventuellen Temperaturabfall zu kompensieren. Der Wärmespeicher 30 hat z.B. eine große thermische Masse und kann vorzugsweise auf der zum Substrat 20 hin weisenden Seite schwarz, aber auf allen anderen Flächen oder zumindest auf der zum Chuck hin weisenden Fläche so präpariert sein, dass die Wärmeabstrahlung minimal ist. Dieser Wärmespeicher 30 kann z.B. auch zusammen mit dem Substrat und dem Substrat-Halter für die Beschichtung hin- und herbewegt werden, um ein Abkühlen des Substrats während der Beschichtung zu minimieren.

In einer Ausführungsform können die Lampen des Strahlungsheizers Beschichtungen mit Filterschichten aufweisen, so dass das abgestrahlte Infrarot-Licht nur solche Wellenlängen enthält, die entweder vor allem vom Substrat (typischerweise Silizium) oder aber alternativ vor allem von dem bereits aufgebrachten Schichtsystem absorbiert werden.

Die vorliegende Erfindung ermöglicht somit ein schnelles Heizen und Abkühlen eines zu beschichtenden Substrats auf definierte Temperaturen, gegebenenfalls mit sofortiger anschließender Beschichtung, so dass sehr effektiv mehrere Schichten bei unterschiedlichen Temperaturen in kürzester Zeit auf das Substrat aufgebracht werden können.

## Patentansprüche

1. Verfahren zum Heizen eines Substrats (20) und sofort anschließender Beschichtung in einer Vakuumkammer mit den folgenden Schritten:
(a) Anordnen des Substrats (20) auf einer Substrat-Halterung (24), so dass die Unterseite (21 a) des Substrats die Substrat-Halterung flächig kontaktiert;
(b) Anheben des Substrats (20) relativ zur Substrat-Halterung um einen Abstand d;
(c) Heizen des angehobenen Substrats über seine Oberseite (21b) mit einer Heizvorrichtung (22),
(d) sofortiges anschließendes Beschichten des heißen Substrats, und
(e) Absenken des Substrats auf die Substrat-Halterung (24) und Abkühlen des Substrats.

2. Verfahren nach Anspruch 1, wobei das abgekühlte Substrat beschichtet wird.

3. Verfahren nach Anspruch 1, wobei die Heizvorrichtung (22) über einen Temperatursensor (26, 28) zum Ermitteln der Substrat-Temperatur und über eine Temperatursteuervorrichtung zum Einstellen einer vorgegebenen Temperatur gesteuert wird.

4. Verfahren nach Anspruch 1, wobei Schritt (d) ein sofortiges Bewegen des geheizten Substrats zusammen mit der Substrat-Halterung (24) in die Beschichtungsposition und das Beschichten des Substrats umfasst.

5. Verfahren nach Anspruch 1, 2 oder 3, wobei das Substrat (20) im Verfahrensschritt (d) um 0,1 bis 20 mm, insbesondere um 1 bis 10 mm, gegenüber der Substrat-Halterung (24) angehoben wird.

6. Verfahren nach Anspruch 1, wobei die Heizvorrichtung aus Infrarot-Strahlern unter Verwendung von Filterschichten besteht, so dass das abgestrahlte Infrarot-Licht nur solche Wellenlängen enthält, die entweder vom Substrat oder von dem bereits aufgebrachten Schichtsystem absorbiert werden.

7. Verfahren nach einem der Ansprüche 1 bis 6, mit dem Schritt:
Anordnen eines Wärmespeichers (30) zwischen die Substrat-Halterung (24) und das angehobene Substrat (20).

8. Verfahren nach einem der Ansprüche 1 bis 7, wobei die Substrat-Halterung (24) gekühlt wird.

9. Verfahren nach Anspruch 1 oder 8, wobei das gekühlte Substrat sofort nach dem Abkühlen zusammen mit der Substrat-Halterung (24) in die Beschichtungsposition bewegt und dort beschichtet wird.

10. Verfahren nach einem der Ansprüche 1 bis 9, wobei ein Temperieren des Substrats auf verschiedene Temperaturen mit jeweils anschließender Beschichtung in mehreren Einzelschritten sequentiell abgearbeitet wird.

11. System zum Heizen eines Substrats (20) in einer Vakuumkammer mit
- einer Substrat-Halterung (24),
- einer Hubvorrichtung (23) zum Anheben des Substrats (20), das mit seiner Unterseite (21a) auf der Substrat-Halterung (24) angeordnet ist, und
- einer Heizvorrichtung (22) zum Heizen des angehobenen Substrats (20) über dessen Oberseite.

12. System nach Anspruch 11, wobei die Hubvorrichtung (23) derart konfiguriert ist, einen signifikanten Wärmestrom zwischen Substrat-Halterung (24) und Substrat (20) zu verhindern.

13. System nach Anspruch 11 oder 12, wobei die Substrat-Halterung (24) mindestens einen Kanal für ein Kontaktgas und das System insbesondere eine Steuerung zur kontrollierten Kühlung der Substrat-Halterung (24) aufweist.

14. System nach einem der Ansprüche 11 bis 13, mit einem Temperatur-Sensor (26, 28) zum gesteuerten Heizen des Substrats (20).

15. System nach einem der Ansprüche 11 bis 14, wobei sich die Hubvorrichtung an der Substrat-Halterung (24) befindet.

16. System nach einem der Ansprüche 11 bis 15, wobei die Substrat-Halterung (24), insbesondere mit dem Substrat (20), in eine Richtung parallel (25) zur Substratunterseite (21a) bewegbar ist.
